# EUROPÄISCHE PATENTSCHRIFT

(11) **EP 0 474 009 B1**
(45) Veröffentlichungstag und Bekanntmachung des Hinweises auf die Patenterteilung: **04.06.1997**
(21) Anmeldenummer: 91113842.8
(22) Anmeldetag: 19.08.1991
(51) Int. Cl.: G03F 7/031, G03F 7/032

(54) **Photopolymerisierbares Gemisch und daraus hergestelltes photopolymerisierbares Aufzeichnungsmaterial**
Photopolymerisable composition and photopolymerisable recording material produced therefrom
Composition photopolymérisable et matériau d'enregistrement photo-polymérisable produit à partir de celle-ci

(30) Priorität: 29.08.1990 DE 4027301
(43) Veröffentlichungstag der Anmeldung: 11.03.1992
(73) Patentinhaber: MORTON INTERNATIONAL, INC., Chicago Illinois 60606-1596 (US)
(72) Erfinder: Geissler, Ulrich, Dr., W-6203 Hochheim/Main (DE); Frommeld, Hans-Dieter, Dr., W-6200 Wiesbaden (DE); Ruckert, Hans, Dr., W-6200 Wiesbaden Naurod (DE)
(74) Vertreter: Weber, Dieter, Dr.

(56) Entgegenhaltungen:
- EP-A- 0 287 516
- EP-A- 0 298 030
- EP-A- 0 299 591
- EP-A- 0 333 224

## Beschreibung

Die Erfindung betrifft ein photopolymerisierbares Gemisch, das als wesentliche Bestandteile ein polymeres Bindemittel, eine ethylenisch ungesättigte radikalisch polymerisierbare Verbindung und einen Photoinitiator enthält. Sie betrifft ferner ein photopolymerisierbares zeichnungsmaterial aus einem Schichtträger und einer photopolymerisierbaren Schicht, die aus dem vorstehend genannten Gemisch besteht. Gemische und Materialien dieser Art dienen zur Herstellung von Druckplatten, Reliefbildern und Photoresists.

Aus der Patentliteratur ist eine große Anzahl an Photoinitiatoren bekannt. Beispiele sind Benzophenon, 4,4'-Bis-dialkylamino-benzophenone, Anthrachinone, thonderivate, Benzoine, Benzoinether, 2,4,5-Triarylimidazolyldimere, Acridin-, Phenazin-, Chinolinderivate oder Trichlormethylverbindungen, insbesondere Trichlormethyl-s-triazine.

Auch Kombinationen aus zwei oder mehreren Arten von Photoinitiatoren sind beschrieben, z. B. Kombinationen von 4,4'-Bis-dialkylamino-benzophenon mit Benzophenon oder anderen Verbindungen, Kombinationen von Benzoylmethylen-N-alkyl-naphthothiazolin und Trihalogenmethyltriazinen, Kombinationen aus einem 2,4,5-Triaryl-imidazolyldimeren und einem p-Aminophenylketon, Kombinationen von Dimethylthioxanthon und 4-Dialkylamino-benzoesäureestern (JP-A 82/23 602), Kombinationen von N-heterocyclischen Verbindungen, besonders Acridinverbindungen, mit Trichlormethylgruppen enthaltenden Verbindungen (EP-A 243 784) und Kombinationen aus diesen zwei Komponenten und photoreduzierbaren Farbstoffen (EP-A 287 817).

In der DE-A 35 03 113 werden Acylhalogenacetamidderivate sowie Gemische dieser Photoinitiatoren mit 4,4'-Bis-dialkylamino-benzophenonen, Benzophenonderivaten oder cyclischen Ketonen beschrieben. Gegenstand der US-A 3 661 588 sind Photoinitiatormischungen, bestehend aus einem p-Aminophenylketon und einer aktiven Methylen- oder Aminoverbindung. In der DE-A 26 10 842 wird ein Gemisch aus N-Phenylacridon und Trihalogenmethylverbindungen beschrieben.

Auch ternäre Photoinitiatorsysteme sind bekannt, so z. B. ein Gemisch aus einem 4,4'-Bis-dialkylamino-benzophenon, einem Benzophenonderivat und einer Verbindung mit einer Trihalogenmethylgruppe (DE-A 33 39 228).

Ein wichtiges Anwendungsgebiet solcher Gemische ist die Herstellung von Trockenresistmaterialien. Da hierbei Photoresistschichten einer Dicke in der Größenordnung von 10 bis 100 µm eingesetzt werden, kommt es darauf an, daß die Flanken der entwickelten Resistlinien möglichst senkrecht verlaufen, damit die auf dem Substrat, z. B. der Leiterplatte, abgedeckte Linie auch möglichst genau der Vorlage entspricht. An Trockenresists werden daher insbesondere drei Anforderungen gestellt:
1.) Hohe Lichtempfindlichkeit,
2.) Hohe Auflösung,
3.) Senkrechte Flankenform.

Mit den bekannten Photoinitiatorkombinationen konnte zwar die Lichtempfindlichkeit wesentlich gesteigert werden, jedoch gelang es bisher nicht, zugleich die beiden anderen Eigenschaften zu verbessern. In der Regel bedingt eine hohe Lichtempfindlichkeit eine positive Flankenstruktur, d. h. es entsteht eine Resistlinie, die an der Basis breiter ist als an der Oberkante. Eine positive oder negative Flankenform hat wiederum eine schlechtere Auflösung zur Folge.

Aufgabe der Erfindung war es, ein photopolymerisierbares Gemisch vorzuschlagen, das den drei vorstehend genannten Anforderungen gerecht wird.

Gegenstand der Erfindung ist ein photopolymerisierbares Gemisch, das als wesentliche Bestandteile
a) ein polymeres Bindemittel,
b) eine radikalisch polymerisierbare Verbindung mit mindestens einer endständigen ethylenischen Doppelbindung und
c) eine als Photoinitiator wirksame N-heterocyclische Verbindung
enthält.

Das erfindungsgemäße Gemisch ist dadurch gekennzeichnet, daß es als weitere Photoinitiator-Komponenten
d) ein Thioxanthonderivat der Formel I 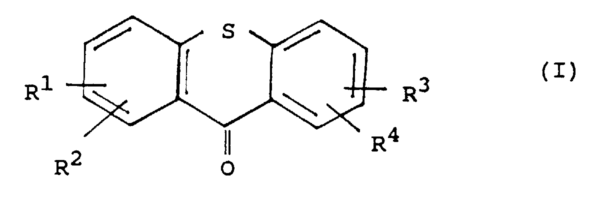 und
e) eine Dialkylaminoverbindung einer der Formeln II oder III 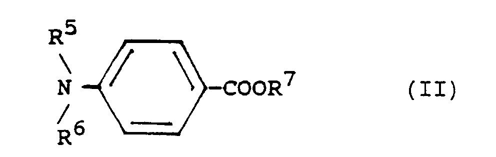 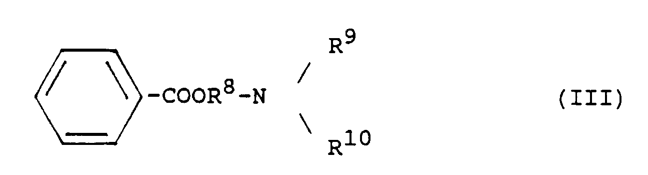 enthält, worin
   - R¹, R²,: Wasserstoff- oder Halogenatome oder
   - R³ und R⁴: Alkyl-, Alkoxy-, Carboxyl-, Alkoxycarbonyl- oder Aryloxycarbonylgruppen,
   - R⁵, R⁶, R⁹ und R¹⁰: Alkylgruppen,
   - R⁷: eine Alkyl- oder Alkoxyalkylgruppe und
   - R⁸: eine Alkylengruppe
bedeuten.

Erfindungsgemäß wird ferner ein photopolymerisierbares Aufzeichnungsmaterial mit einem Schichtträger und einer photopolymerisierbaren Schicht vorgeschlagen, die als wesentliche Bestandteile
a) ein polymeres Bindemittel,
b) eine radikalisch polymerisierbare Verbindung mit mindestens einer endständigen ethylenischen Doppelbindung und
c) eine als Photoinitiator wirksame N-heterocyclische Verbindung
enthält.

Das erfindungsgemäße Aufzeichnungsmaterial ist dadurch gekennzeichnet, daß die Schicht als weitere Photoinitiator-Komponenten die vorstehend genannten Verbindungen (d) und (e) enthält.

Die Thioxanthone der Formel I sind vorzugsweise Verbindungen, in denen mindestens zwei der Reste R¹ bis R⁴, vorzugsweise drei dieser Reste Wasserstoffatome sind. Wenn diese Reste Alkyl- oder Alkoxyreste sind oder enthalten, können diese im allgemeinen 1 bis 6, insbesondere 1 bis 4 Kohlenstoffatome enthalten. Als Aryloxycarbonylgruppen werden Phenyloxycarbonylgruppen bevorzugt, die ggf. durch Halogenatome oder C₁-C₃-Alkylgruppen substituiert sind. Als Halogenatome werden Chlor- und Bromatome bevorzugt.

In den Dialkylaminoverbindungen der Formeln II und III sind R⁵, R⁶, R⁹ und R¹⁰ Alkylgruppen mit im allgemeinen 1 bis 8, vorzugsweise 1 bis 4 Kohlenstoffatomen. R⁷ ist im allgemeinen eine Alkylgruppe mit 1 bis 6, vorzugsweise 1 bis 3, oder eine Alkoxyalkylgruppe mit 2 bis 8, vorzugsweise 3 bis 6 Kohlenstoffatomen. R⁸ hat im allgemeinen 2 bis 6 Kohlenstoffatome.

Bevorzugt werden Verbindungen der Formel I mit R¹ = Alkyl und R² bis R⁴ = Wasserstoff und als Coinitiatoren Verbindungen der Formel II.

Beispiele für bevorzugte N-heterocyclische Verbindungen sind in der DE-A 20 27 467 beschrieben. Es handelt sich hierbei um Verbindungen vom Acridin- oder Phenazintyp, die in einem der äußeren aromatischen Ringe ein weiteres Stickstoffatom als Heteroatom und an diesen Ringen bis zu zwei anellierte Benzolringe enthalten können und die ferner bis zu drei Substituenten tragen können, die gleich oder verschieden sind und H, Halogen, Alkyl-, Alkoxy-, Aryl-, Aryloxy-, Amino-, Acylamino- oder Aralkenylreste sind.

Als weitere N-heterocyclische Verbindungen sind Chinoxaline und Chinazoline zu nennen, wie sie in der DE-A 20 39 861 beschrieben sind. Ebenso sind die in der EP-A 374 704 beschriebenen substituierten Acridine geeignet.

Weitere Beispiele sind in der EP-A 220 589 beschrieben. Es handelt sich dabei um Chinoline, insbesondere 2,3-Dihydro-1H-cyclopenta[b]chinoline der allgemeinen Formel IV 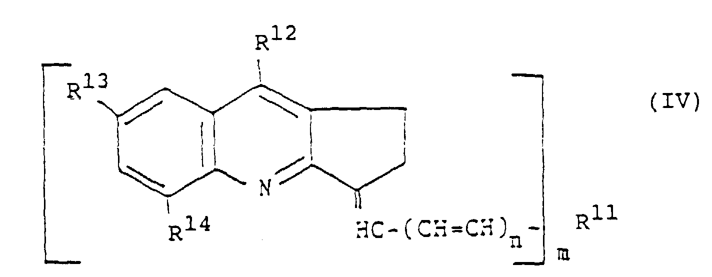 worin
- R¹¹: ein substituierter oder unsubstituierter m-wertiger carbo- oder heterocyclischer aromatischer Rest,
- R¹²: ein Wasserstoffatom, ein Alkyl-, Aryl-, Aralkyl- oder Aralkenylrest ist,
- R¹³ und R¹⁴: gleich oder verschieden sind und Wasserstoff- oder Halogenatome, Alkyl- oder Alkoxyreste bedeuten,
- n: 0 oder 1 und
- m: 1 oder 2 ist.

Auch 2-(Aryl-vinyl)- und 2-(4-Aryl-butadienyl)chinoline, wie sie in der EP-A 11 786 beschrieben sind, sind als N-Heterocyclen geeignet.

Beispiele für N-heterocyclische Verbindungen sind: 9-Phenylacridin, 9-(p-Tolyl)-acridin, 9-(4-Methoxyphenyl)-acridin, 9-(4-Hydroxyphenyl)-acridin, 9-Acetylamino-acridin, Benz[a]phenazin, 8-Methyl-benz[a]-phenazin, 9,10-Dimethyl-benz[a]phenazin, 9-Methylbenz[a]-phenazin, 10-Methyl-benz[a]phenazin, 9-Methoxybenz[a]-phenazin, 10-Methoxy-benz[a]phenazin, Dibenz[a,c]phenazin, 11-Methoxy-dibenz[a,c]phenazin, Dibenz[a,j]phenazin, davon insbesondere 9-Phenylacridin, 9-(p-Tolyl)-acridin, Benz[a]-phenazin und 9-Methylbenz[a]phenazin, Chinoxalinderivate, z.B. 6,4',4"-Trimethoxy-2,3-diphenylchinoxalin, 4',4"-Dimethoxy-2,3-diphenyl-5-azachinoxalin, Chinazolinderivate, 2-Styrylchinolin, Cinnamylidenchinaldin und 3-(o-Chlor-benzyliden)-9-phenyl-2,3-dihydro-1H-cyclopenta[b]chinolin.

Die N-heterocyclische Verbindung wird in einer Menge von 0,01 bis 3,0, vorzugsweise 0,05 bis 1,0 Gew.-% eingesetzt.

Die Menge an Thioxanthon und Dialkylaminoverbindung beträgt je 0,1 bis 4,0 Gew.-%, bevorzugt 0,2 bis 2,0 Gew.-%. Dabei werden im allgemeinen 0,3 bis 3, vorzugs0,5 bis 2 Gewichtsteile Thioxanthon je Gewichtsteil Dialkylaminoverbindung eingesetzt.

Das Mengenverhältnis von Thioxanthon + Dialkylaminoverbindung zu N-heterocyclischer Verbindung liegt im allgemeinen im Bereich von 1:1 bis 20:1, vorzugsweise zwischen 2:1 und 15:1.

Die erfindungsgemäßen Gemische enthalten polymerisierbare Verbindungen mit mindestens einer, vorzugsweise mindestens zwei endständigen ethylenischen Doppelbindungen. Als polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylen- oder Polypropylenglykole mit Molekulargewichten von 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Mit Vorteil werden auch Urethangruppen enthaltende Bisacrylate und Bismethacrylate eingesetzt, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben.

Der Mengenanteil der Schicht an Monomeren beträgt im allgemeinen etwa 10 bis 75, vorzugsweise 20 bis 60 Gew.-%.

Als Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, vinylalkohol, Polyethylenoxid, Polydimethylacrylamid, Polyvinylpyrrolidon, Polyvinylmethylformamid, vinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z.B. Gelatine und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, -PO₃H₂, -SO₃H; -SO₂NH-, -SO₂-NH-SO₂- und -SO₂₋NH-CO-.

Als Beispiele hierfür seien genannt: Maleinatharze, Polymerisate aus N-(p-Tolyl-sulfonyl)-carbaminsäure-β-methacryloyloxy-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u.a., wie sie in den DE-A 20 64 080, 23 63 806 oder 34 27 519 beschrieben sind, werden bevorzugt. Mit Erfolg können auch die in der DE-A 38 05 706 beschriebenen Bindemittel auf Basis einer α,β-ungesättigten Carbonsäure, eines Methacrylats, eines Acrylats und einer Verbindung mit einem aromatischen Substituenten eingesetzt werden.

Das Gemisch kann als übliche weitere Bestandteile merisationsinhibitoren, sonstige Stabilisatoren, stoffdonatoren, Lichtempfindlichkeitsregler, Farbstoffe, Leukofarbstoffe, Photooxydationsmittel, z. B. methylphenylsulfon, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen- und Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind beispielsweise Aluminium, Stahl, Zink, Kupfer, Siebe oder Kunststofffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu bearbeitende Werkstück, z. B. auf Leiterplatten-Basismaterial, aufgebracht werden. Im allgemeinen wird zur Herstellung des resistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Folien lassen sich mit in der Trockenresisttechnik üblichen Geräten verarbeiten. In einer handelsüblichen Laminiervorrichtung wird die Deckfolie abgezogen und die Photoresistschicht auf gebohrtes, verkupfertes Basismaterial laminiert. Die so präparierte Platte wird dann durch eine Vorlage belichtet und nach Abziehen der Trägerfolie in bekannter Weise entwickelt.

Als Entwickler sind organische Lösemittel, z. B. Trichlorethan, oder wäßrige, vorzugsweise wäßrig-alkalische Lösungen, z. B. von Alkaliphosphaten, -carbonaten oder -silikaten, geeignet, denen gegebenenfalls kleine Mengen an mit Wasser mischbaren, organischen Lösemitteln oder an Netzmitteln zugesetzt werden können.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzschutzschichten oder Galvanoreserven, auf metallischen Trägern, z. B. Kupfer, verwendet.

Bei Einsatz der erfindungsgemäßen Photoinitiatorkombination erhält man Photoresistschichten mit hoher Lichtempfindlichket, einem hervorragenden Auflösungsvermögen und senkrechten Resistflanken unabhängig von der Filmvorlage (positiv oder negativ). Wenn die N-heterocyclische Verbindung allein als Photoinitiator eingesetzt wird, werden eine reduzierte Auflösung und positive Resistflanken erhalten, was insbesondere für Galvanoanwendungen von Nachteil ist. Das Thioxanthon/Amin-Gemisch allein ergibt eine geringere Lichtempfindlichkeit mit ungenügender Durchhärtung des Resistsockels. Bei Einsatz einer Positivvorlage (Galvanoanwendung) werden dabei positive, bei Einsatz einer Negativvorlage (Ätzanwendung) negative Flanken ausgebildet. Beides ist für den praktischen Einsatz von Nachteil.

Die folgenden Beispiele erläutern bevorzugte Ausführungsformen der Erfindung. Mengenverhältnisse und Prozentzahlen sind in Gewichtseinheiten zu verstehen, wenn nichts anderes angegeben ist. Die Mengen an Bestandteilen sind in der Regel in Gewichtsteilen (Gt) angegeben. Das Zeichen (V) hinter einer Beispielsvariante gibt an, daß es sich um ein Vergleichsbeispiel handelt.

### Beispiel 1

In Stammlösungen aus je

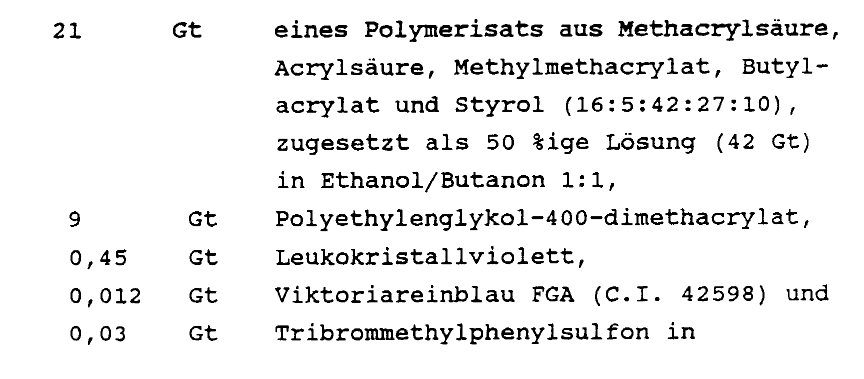

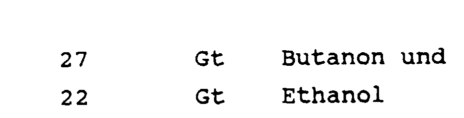

wurden als Photoinitiatoren

| | | |
|---|---|---|
| A (V) | 0,06 Gt | 9-Phenylacridin, |
| | | |
| B (V) | 0,24 Gt | Isopropylthioxanthon und |
| | 0,30 Gt | 4-Dimethylamino-benzoesäureethylester oder |
| | | |
| C | 0,06 Gt | 9-Phenylacridin, |
| | 0,24 Gt | Isopropylthioxanthon und |
| | 0,30 Gt | 4-Dimethylamino-benzoesäureethylester |

gelöst.

Die Lösungen wurden auf biaxial verstreckte und thermofixierte Polyethylenterephthalatfolien von 25 µm Stärke so aufgeschleudert, daß nach dem Trocknen bei 100 °C jeweils ein Schichtgewicht von 45 g/m² erhalten wurde.

Die so hergestellten Trockenresistfolien wurden mit einer handelsüblichen Laminiervorrichtung bei 115 °C auf mit 35 µm starker Kupferfolie kaschierte Phenolharz-Schichtstoffplatten laminiert. Anschließend wurde durch die unten beschriebenen Belichtungsvorlagen 1 bzw. 2 mit einer 5-kW-Metallhalogenidlampe in einem Vakuumkopierrahmen 5 s, durch die Belichtungsvorlage 3 8 s belichtet und dann mit 1 %iger Sodalösung entwickelt.

| Belichtungsvorlage 1 | | dunkel | 47 µm (Linien) |
|---|---|---|---|
| | | transparent | 300 µm (Abstände) |
| Breite des freigelegten Kanals (Oberkante/ Unterkante) | A (V) | - | nicht aufgelöst |
| | B (V) | 71/58 µm | positive Resistflanken keine 1 : 1 Wiedergabe Resistabhebung |
| | C | 47/47 µm | senkrechte Resistflanken 1 : 1 Wiedergabe |

| Belichtungsvorlage 2 | | dunkel | 300 µm |
|---|---|---|---|
| | | transparent | 46 µm |
| Breite der Resistlinie (Oberkante/Unterkante) | A (V) | 46/50 µm | positive Resistflanken |
| | B (V) | 34/31 µm | negative Resistflanken keine 1 : 1 Wiedergabe Resistabhebung |
| | C | 45/45 µm | senkrechte Resistflanken 1 : 1 Wiedergabe |

| Belichtungsvorlage 3 | | dunkel | 71 µm |
|---|---|---|---|
| | | transparent | 300 µm |
| Kanal (Oberkante/Unterkante) | A (V) | - | nicht aufgelöst |
| | B (V) | 85/76 µm | positive Resistflanken keine 1 : 1 Wiedergabe |
| | C | 69/69 µm | senkrechte Resistflanken 1 : 1 Wiedergabe |

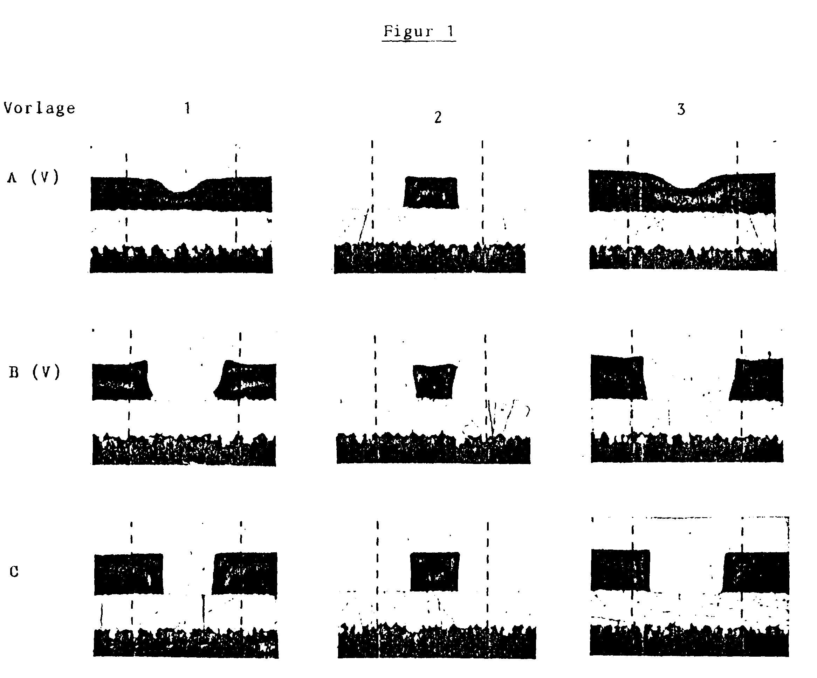

Die beiliegenden Bilder (Fig. 1) zeigen mikroskopische Aufnahmen von Querschnitten durch die entsprechenden Resistmuster.

### Beispiel 2

Zu Stammlösungen aus je

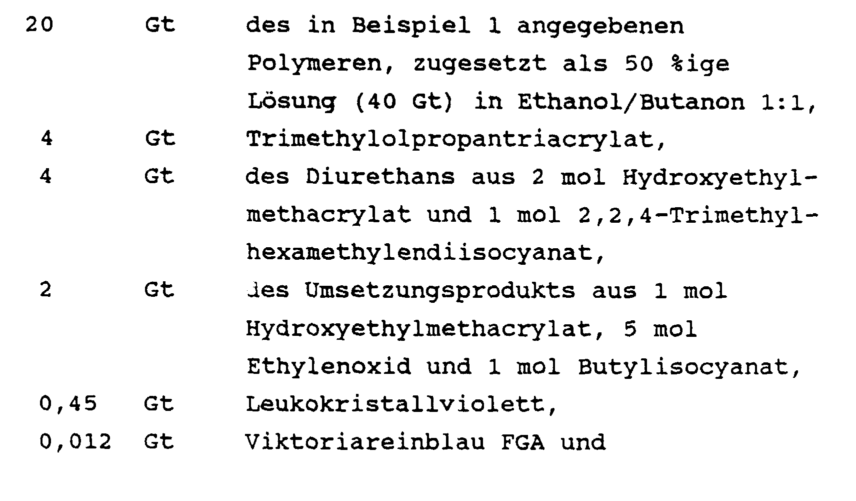

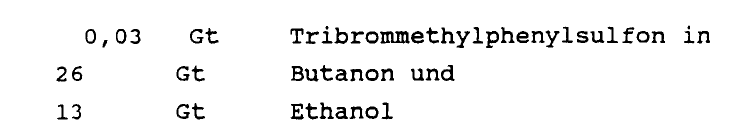

wurden als Photoinitiatoren

| | | |
|---|---|---|
| A (V) | 0,06 Gt | 9-(4-Methoxy-phenyl)-acridin, |
| | | |
| B (V) | 0,24 Gt | Isopropylthioxanthon und |
| | 0,30 Gt | 4-Dimethylamino-benzoesäureethylester oder |
| | | |
| C | 0,06 Gt | 9-(4-Methoxy-phenyl)-acridin, |
| | 0,24 Gt | Isopropylthioxanthon und |
| | 0,30 Gt | 4-Dimethylamino-benzoesäureethylester |

zugesetzt.

Durch Aufschleudern wurden wie in Beispiel 1 beschrieben Trockenresistschichten hergestellt. Es wurde laminiert, 9 s durch die unten beschriebenen Belichtungsvorlagen 4, 5 und 6 belichtet und in 1 %iger Sodalösung entwickelt.

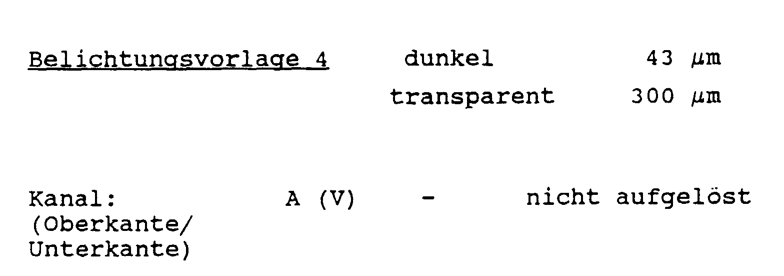

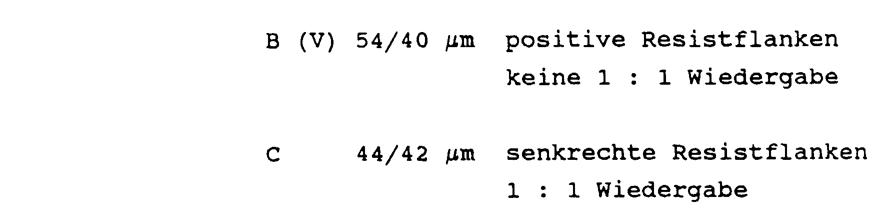

| Belichtungsvorlage 5 | | dunkel | 56 µm |
|---|---|---|---|
| | | transparent | 300 µm |
| Kanal: (Oberkante/Unterkante) | A (V) | 58/42 µm | positive Resistflanken keine 1 : 1 Wiedergabe |
| | B (V) | 70/61 µm | wie A |
| | C | 56/54 µm | senkrechte Resistflanken 1 : 1 Wiedergabe |

| Belichtungsvorlage 6 | | dunkel | 65 µm |
|---|---|---|---|
| | | transparent | 300 µm |
| Kanal: (Oberkante/Unterkante) | A (V) | 65/45 | positive Resistflanken keine 1 : 1 Wiedergabe |
| | B (V) | 77/69 µm | wie A |
| | C | 66/64 µm | senkrechte Resistflanken 1 : 1 Wiedergabe |

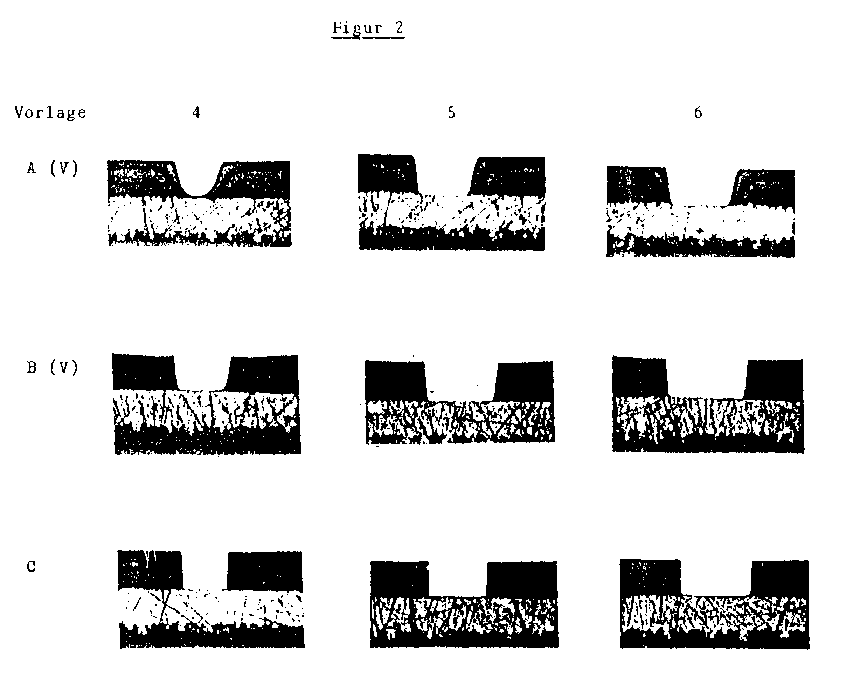

Phenylacridin führt zu einer schlechteren Auflösung, verbunden mit der Ausbildung stark positiver Resistflanken und abgerundeten Resistkanten. Das Thioxanthon/Amin-Gemisch ergibt eine reduzierte Lichtempfindlichkeit und keine 1 : 1 Wiedergabe der Strukturen. Außerdem ist die Resistflankenform positiv, insbesondere bei feinen Strukturen. Schnittbilder der Muster sind in Fig. 2 wiedergegeben.

### Beispiel 3

Vier Stammlösungen aus je

| | |
|---|---|
| 54 Gt | eines Polymerisats aus Methacrylsäure, Methylmethacrylat und Hexylmethacrylat (35:5:60), |
| 16 Gt | des Diurethans aus 2 mol Hydroxyethylmethacrylat und 1 mol 2,2,4-Trimethyl-hexamethylendiisocyanat, |
| 30 Gt | Polyethylenglykol-400-dimethacrylat, |
| 0,1 Gt | 1,4-Bis-(4-tert.butoxy-phenylamino)-5,8-dihydroxyanthrachinon und |
| 0,05 Gt | Samaronmarineblau HR (CI Disperse Blue 290) in |
| 110 Gt | Butanon und |
| 110 Gt | Ethanol |

wurden

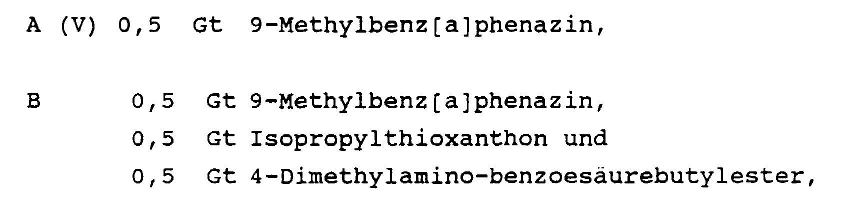

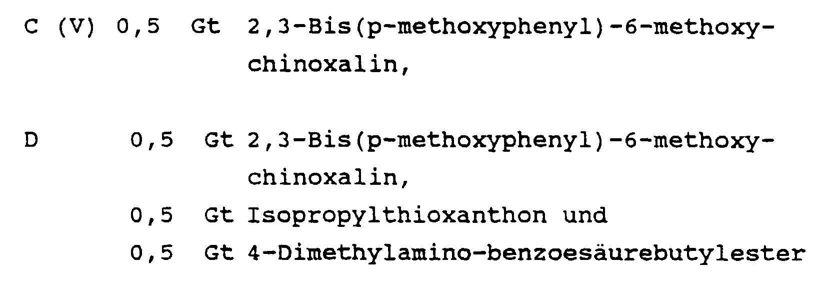

als Photoinitiatoren zugesetzt.

Die Lösungen wurden wie im Beispiel 1 beschrieben auf Polyethylenterephthalatfolie aufgebracht und getrocknet.

Die Folien wurden ebenso auf mit Kupferfolie kaschierte Phenolharz-Schichtstoffplatten laminiert und anschließend unter einer Vorlage, die aus einem Linienmuster mit 50 µm breiten schwarzen Linien und 50 µm breiten Zwischenräumen sowie einem Graustufenkeil bestand, so belichtet, daß nach dem Entwickeln mit 1 %iger Sodalösung (30 °C - 45 Sekunden Sprühen) der Resist unter der Stufe 8 (optische Dichte 1,18) noch ausreichend gehärtet war und stehen blieb, der Resist unter der Stufe 9 (optische Dichte 1.33) aber durch den Entwickler gelöst und entfernt wurde.

Anschließend wurde die Auflösung beurteilt:
Die erfindungsgemäßen Muster B und D gaben das 50 µm-Balkenmuster vorzüglich wieder, bei den Mustern A und C waren die belichteten Balken zusammengewachsen, d.h. auch unter den schwarzen Linien hatte eine gewisse Lichtvernetzung und Photohärtung stattgefunden.

## Patentansprüche

1. Photopolymerisierbares Gemisch, das als wesentliche Bestandteile
a) ein polymeres Bindemittel,
b) eine radikalisch polymerisierbare Verbindung mit mindestens einer endständigen ethylenischen Doppelbindung und
c) eine N-heterocyclische Verbindung als Photoinitiator
enthält, dadurch gekennzeichnet, daß es als weitere Photoinitiator-Komponenten
d) ein Thioxanthonderivat der Formel I 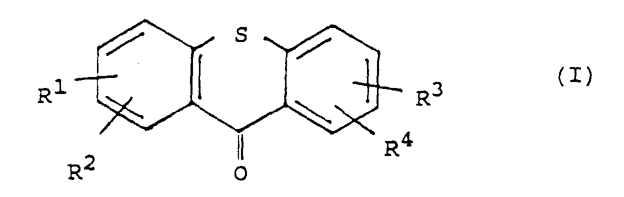 und
e) eine Dialkylaminoverbindung einer der Formeln II oder III 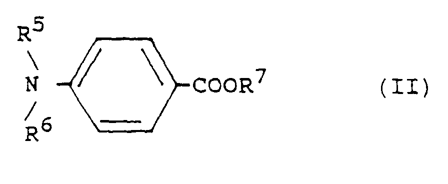 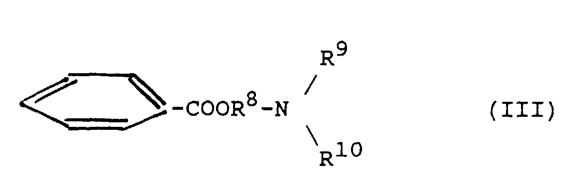 enthält, worin
R¹, R², Wasserstoff- oder Halogenatome oder
R³ und R⁴ Alkyl-, Alkoxy-, Carboxyl-, Alkoxycarbonyl- oder Aryloxycarbonylgruppen
R⁵, R⁶, R⁹ und R¹⁰ Alkylgruppen
R⁷ eine Alkyl- oder Alkoxyalkylgruppe und
R⁸ eine Alkylengruppe
bedeuten.

2. Gemisch nach Anspruch 1, dadurch gekennzeichnet, daß die N-heterocyclische Verbindung eine Acridin-, Phenazin-, Chinoxalin- oder Chinolinverbindung ist.

3. Gemisch nach Anspruch 1, dadurch gekennzeichnet, daß die N-heterocyclische Verbindung in einer Menge von 0,01 bis 3 Gew.-% darin enthalten ist.

4. Gemisch nach Anspruch 1, dadurch gekennzeichnet, daß es je 0,1 bis 4 Gew.-% an Verbindung (d) und Verbindung (e) enthält.

5. Gemisch nach Anspruch 1, dadurch gekennzeichnet, daß es 1 bis 20 Gewichtsteile der Gesamtmenge an (d) + (e) je 1 Gewichtsteil N-heterocyclische Verbindung (c) enthält.

6. Gemisch nach Anspruch 1, dadurch gekennzeichnet, daß das Mengenverhältnis von (d) zu (e) 3:1 bis 1:3 beträgt.

7. Gemisch nach Anspruch 1, dadurch gekennzeichnet, daß das Bindemittel wasserunlöslich und in wäßrigalkalischen Lösungen löslich ist.

8. Gemisch nach Anspruch 1, dadurch gekennzeichnet, daß es 20 bis 90 Gew.-% Bindemittel und 10 bis 75 Gew.-% an polymerisierbaren Verbindungen enthält.

9. Photopolymerisierbares Aufzeichnungsmaterial mit einem Schichtträger und einer photopolymerisierbaren Schicht, die als wesentliche Bestandteile
a) ein polymeres Bindemittel,
b) eine radikalisch polymerisierbare Verbindung mit mindestens einer endständigen ethylenischen Doppelbindung und
c) eine als Photoinitiator wirksame N-heterocyclische Verbindung
enthält, dadurch gekennzeichnet, daß sie als weitere Photoinitiator-Komponenten
d) ein Thioxanthonderivat der Formel I 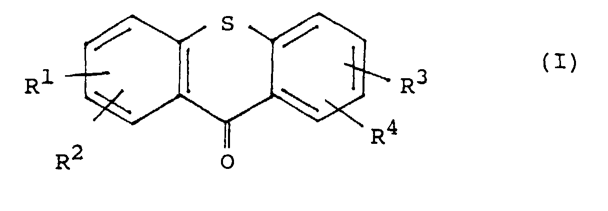 und
e) eine Dialkylaminoverbindung einer der Formeln II oder III 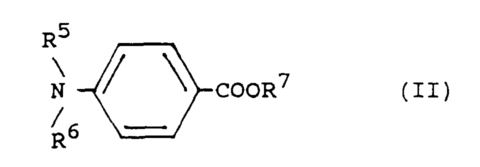 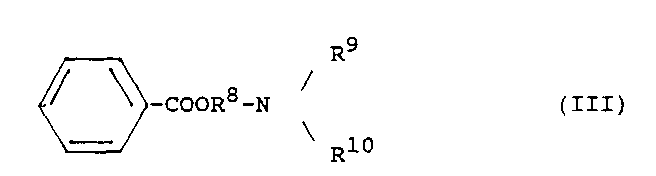 enthält, worin
R¹, R², Wasserstoff- oder Halogenatome oder
R³ und R⁴ Alkyl-, Alkoxy-, Carboxyl-, Alkoxycarbonyl- oder Aryloxycarbonylgruppen
R⁵, R⁶, R⁹ und R¹⁰ Alkylgruppen
R⁷ eine Alkyl- oder Alkoxyalkylgruppe und
R⁸ eine Alkylengruppe
bedeuten.

10. Photopolymerisierbares Aufzeichnungsmaterial nach Anspruch 9, dadurch gekennzeichnet, daß der Schichtträger eine flexible transparente Kunststoffolie ist, die mit der photopolymerisierbaren Schicht abtrennbar verbunden ist und daß die Schicht auf der dem Schichtträger abgewandten Seite eine flexible Abdeckfolie trägt, deren Haftung an der photopolymerisierbaren Schicht geringer ist als die des Schichtträgers.

## Claims

1. Photopolymerizable mixture which contains, as essential components,
a) a polymeric binder,
b) a compound capable of free radical polymerization and having at least one terminal ethylenic double bond and
c) an N-heterocyclic compound as photoinitiator,
characterized in that it contains, as further photoinitiator components,
d) a thioxanthone derivative of the formula I 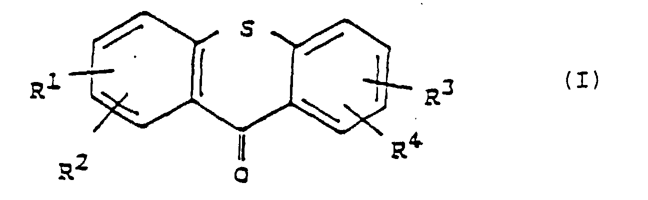 and
e) a dialkylamino compound of one of the formulae II and III 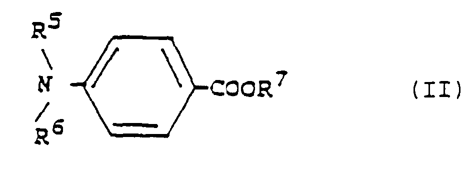 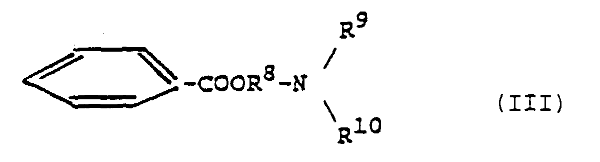 in which
R¹ , R² , R³ and R⁴ are hydrogen or halogen atoms or alkyl, alkoxy, carboxyl, alkoxycarbonyl or aryloxycarbonyl groups,
R⁵, R⁶, R⁹ and R¹⁰ are alkyl groups,
R⁷ is an alkyl or alkoxyalkyl group and
R⁸ is an alkylene group.

2. Mixture according to Claim 1, characterized in that the N-heterocyclic compound is an acridine, phenazine, quinoxaline or quinoline compound.

3. Mixture according to Claim 1, characterized in that the N-heterocyclic compound is contained therein in an amount 0.01 to 3% by weight.

4. Mixture according to Claim 1, characterized in that it contains 0.1 to 4% by weight each of compound (d) and compound (e).

5. Mixture according to Claim 1, characterized in that it contains 1 to 20 parts by weight of the total amount of (d) + (e) per part by weight of N-heterocyclic compound (c).

6. Mixture according to Claim 1, characterized in that the ratio of (d) to (e) is 3:1 to 1:3.

7. Mixture according to Claim 1, characterized in that the binder is water-insoluble and soluble in aqueous alkaline solutions.

8. Mixture according to Claim 1, characterized in that it contains 20 to 90% by weight of binder and 10 to 75% by weight of polymerizable compounds.

9. Photopolymerizable recording material having a substrate and a photopolymerizable layer which contains, as essential components,
a) a polymeric binder,
b) a compound capable of free radical polymerization and having at least one terminal ethylenic double bond and
c) an N-heterocyclic compound effective as a photoinitiator,
characterized in that it contains, as further photoinitiator components,
d) a thioxanthone derivative of the formula I 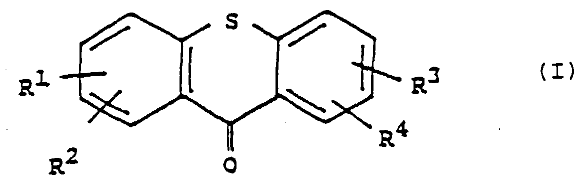 and
e) a dialkylamino compound of one of the formulae II and III 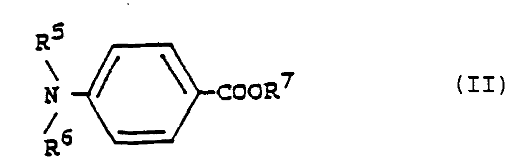 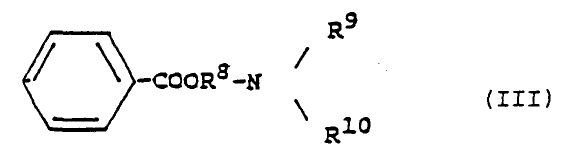 in which
R¹, R², R³ and R⁴ are hydrogen or halogen atoms or alkyl, alkoxy, carboxyl, alkoxycarbonyl or aryloxycarbonyl groups,
R⁵, R⁶, R⁹ and R¹⁰ are alkyl groups,
R⁷ is an alkyl or alkoxyalkyl group and
R⁸ is an alkylene group.

10. Photopolymerizable recording material according to Claim 9, characterized in that the substrate is a flexible transparent plastics film which is detachably connected to the photopolymerizable layer and that the layer carries, on the side facing away from the substrate, a flexible cover film whose adhesion to the photopolymerizable layer is less than that of the substrate.

## Revendications

1. Mélange photopolymérisable qui contient comme composants essentiels
a) un liant polymère,
b) un composé polymérisable par voie radicalaire avec au moins une double liaison éthylénique terminale et
c) un composé N-hétérocyclique efficace comme photoinitiateur,
caractérisé en ce qu'il contient comme autres composants photoinitiateurs
d) un dérivé de thioxanthone de formule I 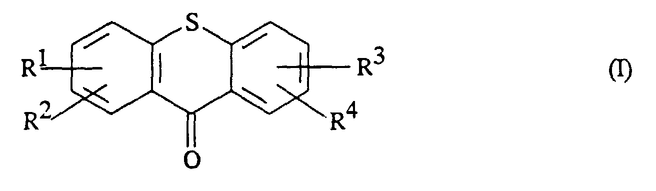 et
e) un composé dialkylamino de l'une des formules II ou III 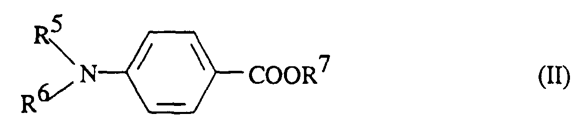 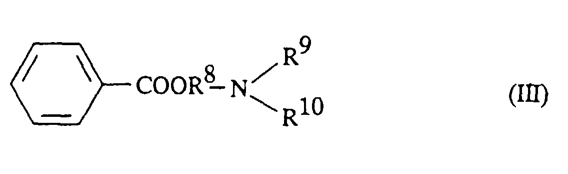 où
R¹, R², R³ et R⁴ représentent des atomes d'hydrogène ou d'halogène ou des groupes alkyle, alcoxy, carboxyle, alcoxycarbonyle ou aryloxycarbonyle,
R⁵, R⁶, R⁹ et R¹⁰ représentent des groupes alkyles,
R⁷ représente un groupe alkyle ou un groupe alcoxyalkyle et
R⁸ représente un groupe alkylène.

2. Mélange selon la revendication 1, caractérisé en ce que le composé N-hétérocyclique est un composé acridine, phénazine, quinoxaline ou quinoléine.

3. Mélange selon la revendication 1, caractérisé en ce que le composé N-hétérocyclique est présent en une quantité de 0,01 à 3 % en poids dans le mélange.

4. Mélange selon la revendication 1, caractérisé en ce qu'il contient respectivement 0,1 à 4 % en poids de composé (d) et de composé (e).

5. Mélange selon la revendication 1, caractérisé en ce qu'il contient 1 à 20 parties en poids de la quantité totale de (d) + (e), respectivement 1 partie en poids de composé N-hétérocyclique (c).

6. Mélange selon la revendication 1, caractérisé en ce que le rapport pondéral de (d) à (e) est de 3:1 à 1:3.

7. Mélange selon la revendication 1, caractérisé en ce que le liant est insoluble dans l'eau et soluble dans les solutions aqueuse alcalines.

8. Mélange selon la revendication 1, caractérisé en ce qu'il contient 20 à 90 % en poids de liant et 10 à 75 % de composés polymérisables.

9. Matériau d'enregistrement photopolymérisable avec un support de couche et une couche photopolymérisable qui contient comme composants essentiels
a) un liant polymère,
b) un composé polymérisable par voie radicalaire avec au moins une double liaison éthylénique terminale et
c) un composé N-hétérocyclique efficace comme photoinitiateur,
caractérisé en ce qu'il contient comme autre composant photoinitiateur caractérisé en ce qu'il contient comme autres composants photoinitiateurs
d) un dérivé de thioxanthone de formule I 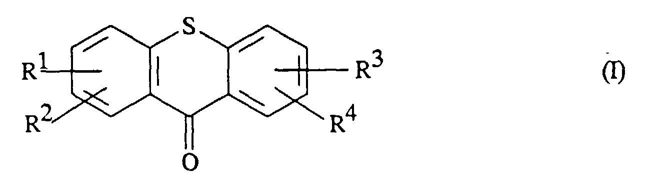 et
e) un composé dialkylamino de l'une des formules II ou III 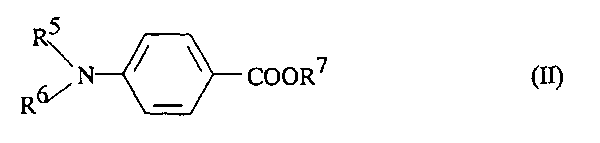 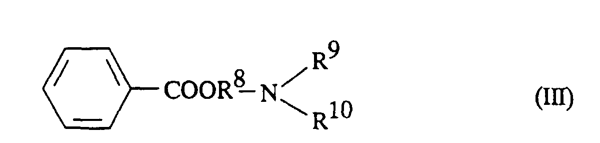 où
R¹, R², R³ et R⁴ représentent des atomes d'hydrogène ou d'halogène ou des groupes alkyle, alcoxy, carboxyle, alcoxycarbonyle ou aryloxycarbonyle,
R⁵, R⁶, R⁹ et R¹⁰ représentent des groupes alkyles,
R⁷ représente un groupe alkyle ou un groupe alcoxyalkyle et
R⁸ représente un groupe alkylène.

10. Matériau d'enregistrement photopolymérisable selon la revendication 9, caractérisé en ce que le support de couche est un film de matière plastique transparent souple, qui est lié de manière séparable à la couche photopolymérisable et que la couche porte sur la face opposée au support de couche un film de couverture flexible, dont l'adhérence pour la couche photopolymérisable est plus faible que l'adhérence pour le support de couche.
